## Europäisches Patentamt
## European Patent Office
## Office européen des brevets

(19)

(11) Veröffentlichungsnummer: **0 145 930**
**B1**

(12) # EUROPÄISCHE PATENTSCHRIFT

(45) Veröffentlichungstag der Patentschrift:
03.02.88

(51) Int. Cl.⁴: **G 01 R 1/073,** H 05 K 13/08

(21) Anmeldenummer: **84113374.7**

(22) Anmeldetag: **06.11.84**

(54) Andruckeinheit für ein Leiterplattenprüfgerät, insbesondere für Keramikleiterplatten.

(30) Priorität: **07.11.83 DE 3340178**

(43) Veröffentlichungstag der Anmeldung:
**26.06.85 Patentblatt 85/26**

(45) Bekanntmachung des Hinweises auf die Patenterteilung:
**03.02.88 Patentblatt 88/5**

(84) Benannte Vertragsstaaten:
**AT BE CH DE FR GB IT LI LU NL SE**

(56) Entgegenhaltungen:
GB-A-1 384 550
US-A-3 792 615

**WESTERN ELECTRIC, TECHNICAL DIGEST, No.43,
Juli 1976, Seiten 5-6, New York (US):
F.W.BECKMAN: "Circuit board test fixture"**

(73) Patentinhaber: **MANIA Elektronik Automatisation
Entwicklung und Gerätebau GmbH, Hauptstrasse
86, D-6384 Schmitten 2 (DE)**
Patentinhaber: **Mang, Paul, Weilbergstrasse 4,
D-6384 Schmitten 3 (DE)**

(72) Erfinder: **Driller, Hubert, Dipl.- Phys.,
Altkönigstrasse 11, D-6384 Schmitten 3 (DE)**
Erfinder: **Mang, Paul, Weilbergstrasse 4, D-6384
Schmitten 3 (DE)**

(74) Vertreter: **Ruschke, Hans Edvard, Patentanwälte
Dipl.- Ing. Olaf Ruschke Dipl.- Ing. Hans E.
Ruschke Dipl,- Ing. Jürgen Rost Dipl.- Chem. Dr.
U. Rotter Pienzenauerstrasse 2, D-8000 München
80 (DE)**

LIBER, STOCKHOLM 1988

## Beschreibung

Die vorliegende Erfindung betrifft eine Andruckeinheit für Keramikleiterplatten, die mit Hilfe eines Leiterplattenprüfgerätes zu testen sind.

Es hat sich zunehmend durchgesetzt, industriell gefertigte Leiterplatten elektronisch zu prüfen, um ein zuverlässiges Ergebnis über die Funktionstüchtigkeit einer Leiterplatte zu erhalten, bevor diese weiterverarbeitet wird, d.h. mit Elektronikbauteilen bestückt wird. Bei einer Leiterplatte mit 1 000 Anschlußpunkten sind zur zuverlässigen Prüfung etwa eine halbe Million Prüfungen auf Zweipunkt-Verbindungen nötig, so daß nur die Anwendung elektronischer Prüfverfahren mit Hilfe eines Rechners eine wirtschaftliche Prüfung in vertretbarer Zeit erlaubt. Derartige komputergesteuerte Leiterplattenprüfvorrichtungen werden durch eine einwandfreie, in die Aufnahme für die zu prüfende Leiterplatte eingelegte "Muster"-Leiterplatte programmiert, wobei alle möglichen Kombinationen von Zweipunkt-Verbindungen selbsttätig in das Programm aufgenommen werden und jede Verbindung auf der Leiterplatte vom Rechner gespeichert wird. Werden anschließend identische Leiterplatten zur Prüfung in die Vorrichtung eingebracht, so findet ein Vergleich jeder einzelnen Zweipunkt-Verbindung mit der Speicherinformation statt, wobei bei fehlender Identität zwischen der gemessenen und der gespeicherten Information eine Fehleranzeige und gegebenenfalls ein Aussortieren der fehlerhaften Leiterplatte stattfindet.

Die Prüfvorrichtung benötigt für jeden Anschlußpunkt der Leiterplatte einen Prüfkontakt, wobei die Konfiguration der Prüfkontakte der Konfiguration der zu überprüfenden Anschlußpunkte der Leiterplatte entsprechen muß. Zu diesem Zweck wird das regelmäßige Raster aus an der Leiterplattenprüfvorrichtung vorgesehenen Kontakten mit einem sogenannten Adapter (Kundenadapter) versehen, welcher im wesentlichen aus nach einem bestimmten Muster angeordneten Kontaktstiften besteht, welches dem Muster der Anschlußpunkte der zu prüfenden Leiterplatte entspricht. Mit anderen Worten: Es wird jeder Kontaktpunkt der Leiterplatte über einen Kontaktstift des Kundenadapters mit einem (beliebigen) Kontaktpunkt des Kontaktpunkt-Grundrasters der Leiterplattenprüfvorrichtung verbunden.

In der DE-A-29 33 862 ist ein derartiger Kundenadapter beschrieben, wobei zur genauen und ohne weiteres reproduzierbaren Positionierung der zu prüfenden Leiterplatte auf dem Adapter mehrere Positionierungsstifte vorgesehen sind, die in dafür vorgesehene Positionsierungsbohrungen in der Leiterplatte eingreifen. Die derart im Verhältnis zu den Kontaktstiften des Kundenadapters positionierte Leiterplatte wird dann durch eine geeignete Andruckvorrichtung gegen die genannten Kontaktstifte gedrückt, damit die rechnergesteuerte Leiterplattenprüfvorrichtung die Prüfroutine durchführen kann.

Selbstverständlich können geeignete Zuführvorrichtungen oder Beschickungsautomaten für die zu prüfenden Leiterplatten vorgesehen sein, damit ein im wesentlichen selbsttätiger Ablauf der Leiterplattenprüfung erreicht wird.

Herkömmliche Leiterplatten haben gewöhnlich einen Kontaktpunktmindestabstand von 1/10" = 2,58 mm. Jeder Kontaktpunkt wird in der Regel durch eine Kontaktpunktbohrung ergänzt, in die die Anschlußdrähte der jeweiligen Elektronikbauteile eingeführt werden, um dort verlötet zu werden. In jüngerer Zeit haben sich jedoch zur Erzielung einer höheren Anschlußdichte Keramikleiterplatten durchgesetzt, bei denen die Kontaktpunkte nur mehr einen Abstand von 1/20" = 1,29 mm haben und bei denen die jeweiligen Kontaktpunkte nicht mehr durch Bohrungen, sondern durch kleinere leitende Punkte oder Felder auf der Keramikoberfläche ausgebildet werden. Es liegt auf der Hand, daß das fließbandmäßige Durchprüfen von vielen derartigen Keramikleiterplatten zu Schwierigkeiten führen kann, da bei diesen Platten in der Regel keine Positionierungsbohrungen vorgesehen sind. In der US-A-3 792 615 ist in der Fig. 6 und der zugehörigen Beschreibung ein Prüfgerät erläutert, bei dem eine zu testende Mikroschaltung unter einem Mikroskop auf einem vertikal verschieblichen Tisch angeordnet wird und zunächst in der horizontalen Ebene in der Weise genau ausgerichtet wird, daß die Anschlußpunkte der Mikroschaltung sich vertikal unterhalb von seitwärts vorstehenden Testsonden befinden, die zum Anschluß der Mikroschaltung an eine abseits aufgestellte Prüfvorrichtung dienen. Die Kontaktierung der Anschlußpunkte der Mikroschaltung mit den genau darüber angeordneten Testsonden erfolgt dann durch Hochfahren des vertikal verschieblichen Tisches.

Eine derartige unmittelbare optische Beobachtung der Ausrichtung zwischen den Anschlußpunkten der zu testenden Schaltung (Leiterplatte) und den Testsonden (Prüfstiften) vor der Kontaktierung zwischen diesen ist bei den hier in Rede stehenden Leiterplattenprüfgeräten nicht möglich, weil letztere denjenigen Bereich einnehmen, von wo aus die Beobachtung erfolgen müßte. Mit anderen Worten: Die Ausrichtung der mit dem Kundenadapter des Leiterplattenprüfgerätes in Kontakt zu bringende Oberfläche kann nicht ohne weiteres beobachtet werden, da sie auf die Kontaktstifte des Kundenadapters aufgedrückt werden muß.

Es ist daher die der vorliegenden Erfindung zugrundeliegende Aufgabe, eine Vorrichtung vorzusehen, durch die eine einwandfreie und schnelle Ausrichtung der zu prüfenden Keramikleiterplatten auf den speziellen Kundenadapter möglich wird. Außerdem soll die Vorrichtung derart ausgebildet sein, daß sie schnell und problemlos justierbar, d.h. auf unterschiedliche Leiterplattenkonfigurationen bzw. Kundenadapter einstellbar ist.

Diese Aufgaben werden erfindungsgemäß durch die Maßnahmen nach den Ansprüchen 1 und 6 gelöst.

Ein Ausführungsbeispiel der vorliegenden Erfindung wird nachfolgend unter Bezugnahme auf die beigefügten Zeichnungen beschrieben. In diesen zeigt:.

Fig. 1 eine prinzipielle Darstellung der Andruckeinheit mit den beiden Lichtmarkenprojektoren; und

Fig. 2 eine Seitenansicht der Fig. 1.

Gemäß dem Ausführungsbeispiel ist vorgesehen, daß eine oberhalb des Kundenadapters angeordneter, um eine horizontale Verschwenkachse 2 drehbare und in senkrechter Richtung verfahrbare Halterung 4 zwei einander gegenüberliegende Flächen 6, 8 aufweist, auf denen jeweils eine (Keramik-) Leiterplatte 10 pneumatisch (durch Unterdruck) fixierbar ist. Auf die der Bedienungsperson zugewandte, d.h. nach oben weisende Fläche (Beschickungsebene (6)), wird eine Keramikleiterplatte aufgelegt, die auf der mit den Kontaktpunkten versehenen Oberfläche zwei besondere Markierungen aufweist, die von der Bedienungsperson auf zwei (beim Einrichten der Vorrichtung) justierte Lichtmarken eingestellt werden, welche von zwei Lichtmarkenprojektoren 12 erzeugt werden. Auf diese Weise kann die zu prüfende Keramikleiterplatte schnell und genau positioniert werden, wonach die pneumatische Fixierung stattfindet und die Halterung 4 der Andruckvorrichtung um ihre horizontale Verschwenkachse verdreht und senkrecht nach unten verfahren wird, was durch geeignete, im Inneren des Blockes vorgesehene Hydraulikelemente bewerkstelligt wird, so daß die genau positionierte Keramikleiterplatte auf den Kundenadapter gedrückt wird. Die auf der in gleicher Weise ausgebildeten gegenüberliegenden Fläche der Halterung 4 angeordnete und zuvor geprüfte Keramikleiterplatte wird gegen eine noch zu prüfende Platte ausgetauscht und mit Hilfe der Markierungen auf der Platte und den Lichtmarken des Lichtmarkenprojektors ausgerichtet. Hiernach wird die Halterung 4 (in senkrechter Richtung) von dem Kundenadapter abgehoben und um ihre horizontale Verschwenkachse 2 um 180° verdreht, so daß die gerade geprüfte Keramikleiterplatte 10 abgenommen und gegen eine neue ausgetauscht werden kann, wie dies zuvor erläutert wurde. Anschließend wird der beschriebene Zyklus wiederholt usw.

Wie bereits angedeutet, ist zum Einrichten der Andruckeinheit eine Justierung der Lichtmarkenprojektoren 12 erforderlich. Zu diesem Zweck wird eine plastische Folie auf einer der Aufnahmeflächen 6, 8 der Halterung fixiert und gegen den Kundenadapter gedrückt, dessen Kontaktstifte genau der Kontaktpunktanordnung der Keramikleiterplatte entsprechen. Der Abdruck dieser Kontaktspitzen auf der Folie dient dann zur Justierung der Strichmarkenprojektoren, was deshalb möglich ist, weil die Lage der Markierungen auf der Platte im Verhältnis zu den Kontaktpunkten zuvor festgelegt sein muß (wurde).

Die Andruckeinheit ist auf einem nicht dargestellten Leiterplattenprüfgerät angeordnet, dessen Kontaktpunkt-Grundrasterplatte durch den untersten Strich in den Zeichnungen angedeutet sein soll. Auf dieses Grundraster ist ein Kundenadapter aufgesetzt der gegebenenfalls - wie im Ausführungsbeispiel der Zeichnung dargestellt - auf einem Reduktionsadapter und einem Zwischenadapter aufsitzt. Letztere sind lediglich dazu vorgesehen, das relativ weite Grundraster eines üblichen Leiterplattenprüfgerätes in ein wesentlich dichteres Grundraster zu überführen, welches für die Prüfung von Keramikleiterplatten geeignet ist.

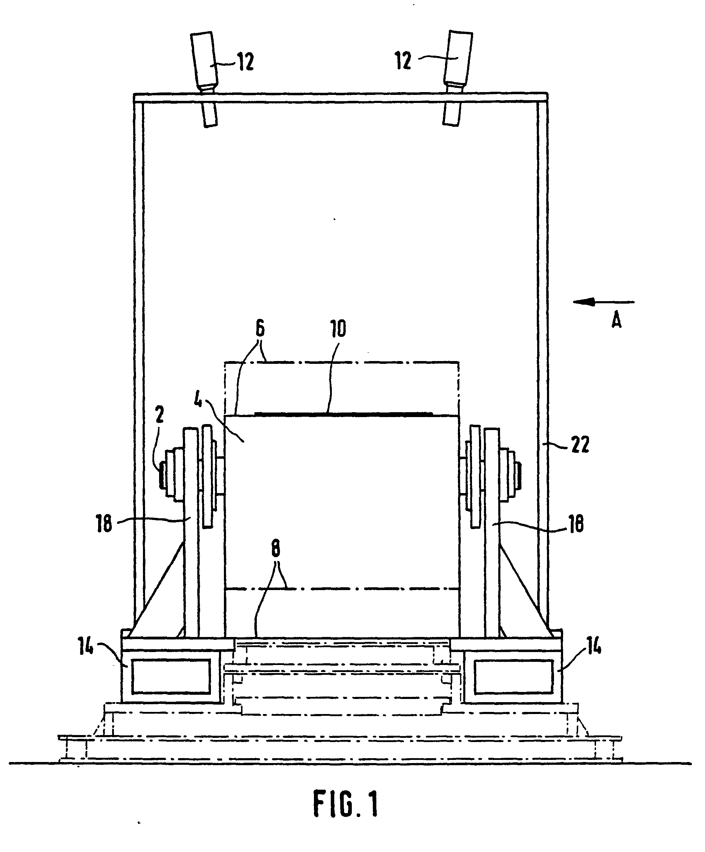

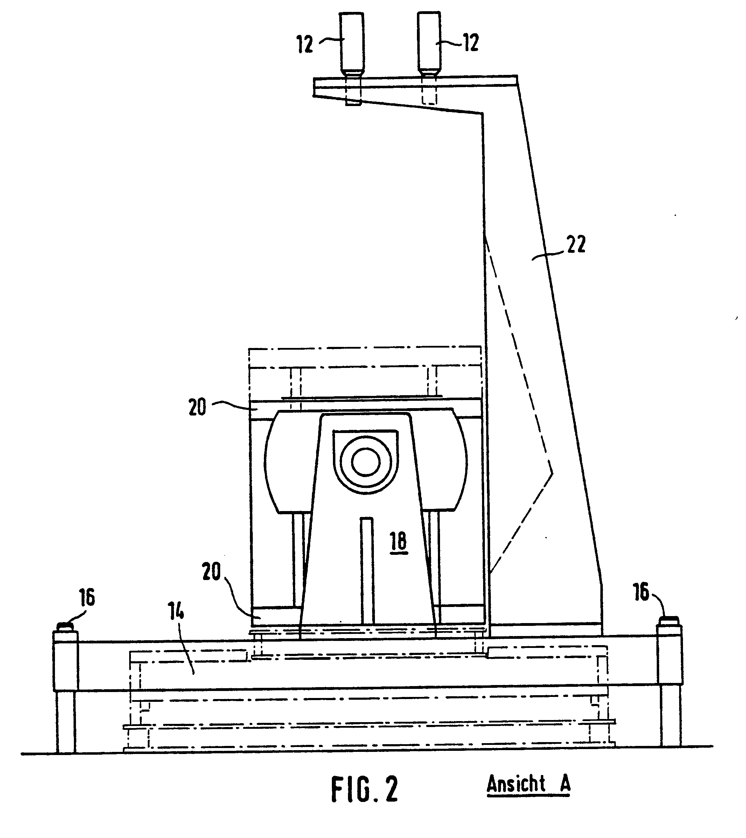

Die Andruckeinheit ist auf einem horizontalen Spannrahmen 14 angeordnet, der, wie aus Figur 2 ersichtlich, mit dem (allerdings nicht dargestellten) Leiterplattenprüfgerät durch senkrecht verlaufende Spannschrauben 16 verbunden ist. Der Spannrahmen trägt einen Lagerbock 18, der die horizontale Verschwenkachse 2 der Andruckeinheit abstützt. Auf dieser horizontalen Achse sitzt die beispielsweise quaderförmige Halterung 4, die oberhalb des Kundenadapters auf der horizontalen Verschwenkachse einerseits senkrecht verfahrbar und andererseits um diese um 180° verschwenkbar ist. Die Verschwenkbarkeit und senkrechte Verfahrbarkeit det Halterung 4 in Richtung auf den Kundenadapter ist dazu vorgesehen, die auf den einander gegenüberliegenden Stirnflächen (Beschickungsebene (6) bzw. Prüfkontaktebene (8)) der Halterung 4 aufbringbaren und fixierbaren Keramikleiterplatten abwechselnd auf den Kundenadapter aufzudrücken, um für den notwendigen Kontaktdruck zu sorgen. In Fig. 1 ist die Position der Halterung 4 durch strichpunktierte Linien in der oberen Stellung gezeigt, in der sie um die horizontale Verschwenkachse 2 drehbar ist und in der ein Austausch der gerade geprüften Keramikplatte 10 gegen die noch zu prüfende Keramikplatte stattfindet. Mit durchgezogenen Linien ist die Halterung 4 in ihrer abgesenkten Stellung dargestellt, in der die Keramikleiterplatte auf den Kundenadapter aufgepreßt wird. Auch in dieser Position kann eventuell der Austausch der gerade geprüften gegen die ungeprüfte Leiterplatte stattfinden.

Eine nicht näher dargestellte Hydraulik oder Pneumatik im Inneren der Halterung 4 dient zum Erzeugen der angedeuteten Auf- und Abbewegung bzw. der notwendigen Anpreßkräfte. Auch die Mechanik zum Erzeugen der um 180° erfolgenden Verschwenkung der Halterung bei jedem Arbeitstakt ist nicht näher dargestellt.

Die Keramikplatte wird auf den einander gegenüberliegenden Stirnflächen der Halterung pneumatisch fixiert, d.h. diese beiden Stirnflächen sind wie in Fig. 2 angedeutet, als Ansaugplatten 20 ausgebildet, wobei auch diese Details nicht näher gezeigt sind. Indem beispielsweise an geeigneten Bohrungen in der Ansaugplatte 20 zum richtigen Zeitpunkt ein gewisser Unterdruck erzeugt wird, kann die Keramikleiterplatte 10 ohne weiteres auf der Ansaugplatte fixiert werden.

Ein wesentliches Element der gesamten Andruckeinheit sind die mittels eines Gestänges oder Ständers 22 oberhalb der Halterung 4 angeordneten zwei Lichtmarkenprojektoren 12, die im Zusammenwirken mit zwei ausgewählten Markierungen auf der Oberfläche der Keramikleiterplatte zur optischen Justierung derselben auf der nach oben Fläche (Beschickungsebene (6)) der Halterung 4 bzw. auf der weisenden Ansaugplatte 20 dienen.

## Patentansprüche

1. Vorrichtung zum Andrücken von in einem Leiterplattenprüfgerät zu testenden Leiterplatten (10) auf einer Anordnung aus entsprechend den Leiterplatten-Anschlußpunkten positionierten Prüfkontakten (Kundenadapter), mit einer Halterung (4), in der die zu testenden Leiterplatten (10) parallel zur Prüfkontaktebene (8) und in Richtung auf diese in eine Prüfstellung verschieblich angeordnet sind, und mit einer Positioniereinrichtung (12) zum exakten Anordnen der zu prüfenden Leiterplatte (10) im Verhältnis zu den Prüfkontakten, dadurch gekennzeichnet, daß die Halterung (4) in der Art verschwenkbar ist, daß die Leiterplatten-Beschickungsseite der Leiterplatten-Beschickungsebene (6) von der Prüfkontaktseite der Prüfkontakt-Ebene (8) abgewandt ist, wobei der Winkel Leiterplatten-Beschickungsseite/Prüfkontaktseite von dem Wert 0° der Prüfstellung abweicht, daß die Positioniereinrichtung aus mindestens einem Lichtmarkenprojektor (12) besteht, welcher zur optischen Positionierung der eine entsprechende Markierung aufweisenden, zu prüfenden Leiterplatte (10) auf der weggeschwenkten Halterung (4) vorgesehen ist, und daß pneumatische, mechanische oder elektromechanische Mittel zum Fixieren der Leiterplatte (10) in der positionierten Lage auf der Halterung (4) vorgesehen sind.

2. Vorrichtung nach Anspruch 1, dadurch gekennzeichnet, daß die zur Aufnahme der zu testenden Leiterplatte vorgesehene Halterung (4) um eine parallel zur Prüfkontaktebene angeordnete Verschwenkachse (2) in der Art verschwenkbar ist, daß der Winkel zwischen Leiterplatten-Beschickungsseite und Prüfkontaktseite 180° beträgt.

3. Vorrichtung nach Anspruch 2, dadurch gekennzeichnet, daß die Halterung (4) eine Ansaugplatte ist, auf der die Leiterplatte (10) pneumatisch durch Unterdruck fixierbar ist.

4. Vorrichtung nach einem der voranstehenden Ansprüche, dadurch gekennzeichnet, daß ein um die Verschwenkachse (2) verschwenkbarer und in Richtung auf die Prüfkontaktebene verfahrbarer Andruckblock (4) vorgesehen ist, von dem zwei einander gegenüberliegende Flächen als Ansaugplatten (20) ausgebildet sind.

5. Vorrichtung nach einem der voranstehenden Ansprüche, dadurch gekennzeichnet, daß die Lichtmarkenprojektoren (12) an einem mit dem Lagerbok (18) der Verschwenkachse (2) verbundenen Gestell (22) oberhalb der Halterung (4) gelagert sind.

6. Vorrichtung nach einem der Ansprüche 1 bis 5, bei der die Justierung der Lichtmarkenprojektoren durchgeführt wird, indem eine Kunststoffolie auf der Halterung (4) fixiert und anchließend auf die Prüfkontakte aufgedrückt wird derart, daß sich ein Abdruck der Prüfkontakte auf dieser Folie ergibt, wonach die mit den Abdrücken versehene, auf der Halterung (4) fixierte Folie in die den Strichmarkenprojektoren zugewandte Stellung zurückgeschwenkt wird, wonach der oder die Strichmarkenprojektoren (12) auf eine Markierung auf der Folie ausgerichtet wird bzw. werden, welche zuvor relativ zu den Abdrücken und damit im Verhältnis zu den Anschlußpunkten der Leiterplatte festgelegt worden ist.

## Claims

Apparatus for pressing circuit boards (10) to be tested in circuit board testing apparatus onto an assembly off test contacts tocated in accordance with the contact positions on the circuit board (customized adapter), comprising a holder (4) holding circuit boards (10) to be tested for movement into a testing position in parallel to and in a direction towards test contact plane (8), and locating means (12) for precisely positioning circuit board (10) with respect to the test contacts, characterized by holder (4) being pivotable in a manner such that the component placement side of circuit board component placement plane (6) faces away from test contact plane (8), with the angle between the component placement side of the circuit board and the test contact side being other than the value of 0 degrees thereof in the testing position, by the locating means comprising at teast one tight marker projector (12) mounted to optically position circuit board (10) under test, which has a corresponding marker thereon, on holder (4) in the non-testing position thereof, and by pneumatic, mechanical or electromechanic means being provided to hold circuit board (10) in position on holder (4).

2. Apparatus as in claim 1, characterized by holder (4) for receiving the circuit board under test is pivotable about a pivoting axis (2) extending in parallel with the test contact plane in a manner such that the angle between the circuit board component placement side and the test contact side is 180 degrees.

3. Appparatus as in claim 2, <u>characterized</u> in that holder (4) comprises a suction plate adapted to fix circuit board (10) by negative pneumatic pressure.

4. Apparatus as in any one off the preceding claims, <u>characterized</u> by a pressure block (4) adapted to be pivoted about pivoting axis (2) and to be moved towards the test contact plane and having two opposite surfaces constructed to form suction plates.

5. Apparatus as in any one off the preceding planes, <u>characterized</u> by light marker projectors (12) being mounted above holder (4) on a frame (22) connected with bearing brackets (19) of pivoting shaft (2).

6. Apparatus as in any one of claims 1 to 5 wherein the light marker projectors are adjusted by placing a plastic film on holder (4) and then pressing it down on the test contacts in a manner such as to cause impressions of the test contacts to form in said film, by pivoting the film on holderv (4) into the position thereof facing the light marker projectors, and by then directing light marker projector(s) (12) to a marker on said film which has previously been fixed relative to said impressions and thus relative to the connecting positions on the circuit board.

**Revendications**

1. Dispositif pour presser des plaquettes de circuits (10) à vérifier dans un appareil de vérification de plaquettes de circuits, sur un agencement de contacts de vérification (adaptateur de client) situés en correspondance avec les points de connexion de plaquette ou carte de circuits, avec un support (4), dans lequel les plaquettes de circuits (10) à essayer sont disposées de manière mobile parallèlement au plan de contacts de vérification (8) et dans la direction vers celui-ci, en une position de vérification, et avec un dispositif de mise en position (12) pour une disposition précise de la plaquette de circuits (10) à vérifier par rapport aux contacts de vérification, caractérisé en ce que le support (4) peut pivoter d'une manière telle que le côté d'alimentation en plaquettes de circuits du plan d'alimentation en plaquettes de circuits (6) soit opposé au côté de contacts de vérification du plan de contacts de vérification (3), l'angle côté d'alimentation en plaquettes de circuits/côté de contacts de vérification différant de la valeur de 0° de la position de vérification, en ce que le dispositif de mise en position est constitué par au moins un projecteur de repères lumineux (12), qui est prévu pour un positionnement optique de la plaquette ou carte de circuits (10) à vérifier, présentant un marquage correspondant, sur le support (4) écarté par pivotement, et en ce que des moyens pneumatiques, mécaniques ou électromécaniques sont prévus pour immobiliser la plaquette de circuits (10) dans la position située sur le support (4).

2. Dispositif suivant la revendication 1, caractérisé en ce que le support (4) prévu pour recevoir la plaquette de circuits à essayer peut pivoter autour d'un axe de pivotement (2) disposé parallèlement au plan de contacts de vérification, d'une manière telle que l'angle entre le côté d'alimentation en plaquettes de circuits et le côté de contacts de vérification.

3. Dispositif suivant la revendication 2, caractérisé en ce que le support (4) est une plaque de succion, sur laquelle la plaquette ou carte de circuits (10) peut être immobilisée pneumatiquement par dépression.

4. Dispositif suivant l'une des revendications précédentes, caractérisé en ce qu'un bloc presseur (4) pouvant pivoter autour de l'axe de pivotement (2) et pouvant être déplacé dans la direction du plan de contacts de vérification est prévu, bloc dont deux surfaces mutuellement opposées sont réalisées en tant que plaques de succion (20).

5. Dispositif suivant l'une des revendications précédentes, caractérisé en ce que les projecteurs de repères lumineux (12) sont supportés au-dessus du support (4), sur un bâti (22) relié au palier (18) de l'axe de pivotement (2).

6. Dispositif suivant une des revendications 1 à 5, dans lequel l'ajustage des projecteurs de repères lumineux est effectué en fixant une feuille de matière synthétique sur le support (4) et en la repoussant ensuite sur les contacts de vérification, de telle sorte qu'il en résulte une empreinte des contacts de vérification sur cette feuille, après quoi la feuille dotée des empreintes, fixée sur le support (4), est ramenée par pivotement à la position dirigée vers les projecteurs de traits de repère, après quoi le ou les projecteurs de traits de repère (12) sont alignés sur un marquage sur la feuille, qui a été déterminé préalablement par rapport aux empreintes et donc en relation avec les points de connexion de la plaquette de circuits.

FIG.1

FIG. 2     <u>Ansicht A</u>